Europäisches Patentamt

European Patent Office

Office européen des brevets

(19)

(11) Publication number: **0 035 361**
**B1**

(12) **EUROPEAN PATENT SPECIFICATION**

(45) Date of publication of patent specification: **27.07.83**

(51) Int. Cl.³: **H 01 L 27/08, H 01 L 29/86**

(21) Application number: **81300772.1**

(22) Date of filing: **25.02.81**

(54) Semiconductor device using resistors each formed of one or more basic resistors of the same pattern.

(30) Priority: **27.02.80 JP 24625/80**

(43) Date of publication of application:
**09.09.81 Bulletin 81/36**

(45) Publication of the grant of the patent:
**27.07.83 Bulletin 83/30**

(84) Designated Contracting States:
**DE FR GB**

(56) References cited:
**US - A - 3 644 802**
**US - A - 3 771 095**
**US - A - 4 161 742**

**IBM TECHNICAL DISCLOSURE BULLETIN, vol. 15, no. 2, July 1972, New York, USA M.A. BATTISTA et al. "Resistor tracking on monolithic integrated circuits", pages 423—424**

(73) Proprietor: **FUJITSU LIMITED**
**1015, Kamikodanaka Nakahara-ku**
**Kawasaki-shi Kanagawa 211 (JP)**

(72) Inventor: **Tamada, Haruo**
**497-28-19-24, Kawakami-cho Totsuka-ku**
**Yokohama-shi Kanagawa 244 (JP)**
Inventor: **Kudo, Osamu**
**44-5, Kitamagome 2-chome Ohta-ku**
**Tokyo 143 (JP)**

(74) Representative: **Sunderland, James Harry et al,**
**HASELTINE LAKE & CO Hazlitt House 28**
**Southampton Buildings Chancery Lane**
**London WC2A 1AT (GB)**

Courier Press, Leamington Spa, England

# O 035 361

### Semiconductor device using resistors each formed of one or more basic resistors of the same pattern

The present invention relates to a semiconductor device having a group of resistors according to the first part of claim 1. Such a device is for instance known from US—A—4 161 742.

In a monolithic semiconductor device such as an AD converter, a DA converter, an operational amplifier etc., formed on one chip, resistors as well as active elements such as transistors are often formed by diffused layers or thin film layers. In such a device, a ratio of one resistance to another resistance is required to have as high an accuracy as possible, in order to deal with an increased number of bits. For example, in an 8-bit AD converter, an analogue signal is divided into $1/2^8$ signals. To divide the analogue signal accurately, the ratios between the resistances included in the AD converter must be within a tolerance of lower than $1/(2 \times 2^8)$. The required accuracy increases along with the increase in the number of bits used by the semiconductor device. For the purpose of fabricating resistors on a semiconductor substrate so as to realize the desired ratios of the resistances with a high accuracy, in a conventional manner, a number of basic resistors are formed each to the same pattern, and then, a desired number of the basic resistors are combined, i.e., connected by wirings, so as to obtain the desired ratios between the resistances. Since all of the resistors have the same pattern, it is much easier to realize accurately desired resistance ratios by connecting basic resistors to provide resistances than to fabricate a resistor of a desired length for each resistance.

However, in the conventional method, although each basic resistor has the same pattern, the resistances of the basic resistors are not always equal to each other.

The difference between the basic resistances is the result of, for example, thermal treatment during a diffusion process or, after the diffusion process, is due to heat sources such as semiconductor elements loaded on the semiconductor substrate. Since the basic resistances are not always accurately equal to each other, the obtained ratios between the resistances are not always equal to the desired ratios. In most cases, there is a linearly changing temperature gradient along one direction on each chip on which the basic resistors are arranged. The invention therefore aims to cancel errors of the resistance values of the basic resistances, increasing or decreasing linearly along one chip direction.

According to the present invention there is provided a semiconductor device comprising a semiconductor substrate, and a group of resistors including a plurality of basic resistors having the same pattern as one another, a predetermined number of the basic resistors being connected to form a resistor having a desired resistance value, wherein the group of resistors comprises a first resistor formed by connecting one or more of the basic resistors arranged on the middle portion of the group, and, a second resistor formed by connecting a plurality of the basic resistors arranged on opposite sides of the first resistor.

Thus, the basic resistor or resistors of the first resistor are disposed between basic resistors of the second resistor.

The basic resistors may be arranged in parallel fashion on the semiconductor substrate.

The present invention can provide a semiconductor device having resistors, in which the accuracy of the ratios between the resistances is improved, for example by taking into account the linearly changing temperature gradient.

The present invention can thus provide such a semiconductor device in which an increased number of bits can be used.

Reference is made, by way of example, to the accompanying drawings, throughout which like reference characters and numerals designate the same or similar parts, and in which:—

Fig. 1A is a plan view of a conventional semiconductor device on which patterns of resistors are connected;

Fig. 1B is an equivalent circuit diagram of Fig. 1A;

Fig. 2A is a plan view of a semiconductor device on which patterns of resistors are connected, according to an embodiment of the present invention;

Fig. 2B is an equivalent circuit diagram of Fig. 2A, and;

Figs. 3 to 6 are equivalent circuit diagrams of semiconductor devices, according to further embodiments of the present invention.

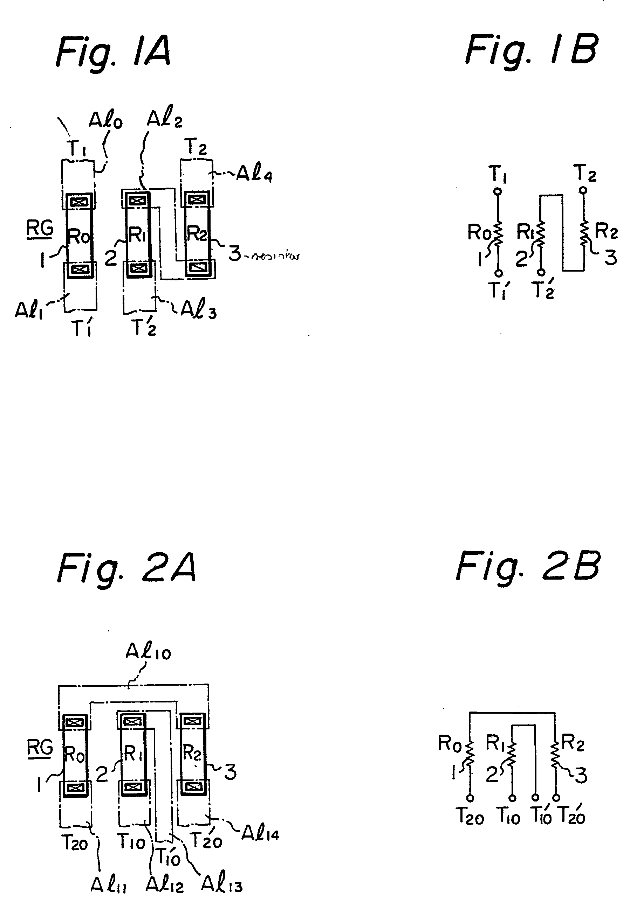

Before describing the embodiments of the present invention, a conventional semiconductor device will first be explained. Fig. 1A is a plan view of a conventional semiconductor device on which patterns of resistors are connected. Referring to Fig. 1A, resistors 1, 2 and 3 having resistances $R_0$, $R_1$ and $R_2$, respectively, are basic resistors formed on a semiconductor substrate (not shown). Each of the basic resistors 1, 2 and 3 is formed by using the same pattern and under the same fabricating process. Therefore, the resistances $R_0$, $R_1$ and $R_2$ of the basic resistors are theoretically the same and are equal to the designed value R. When two resistances having a ratio of 1 to 2 are to be fabricated, both ends of the resistor 1 are connected through aluminum wirings $Al_0$ and $Al_1$, respectively, to terminals $T_1$ and $T_1'$, respectively, to form one resistance R on one hand, and on the other hand, another resistance 2R is formed by connecting one end of the resistor 2 to one end of the resistor 3 through an aluminum wiring $Al_2$, and also by connecting the other ends of the resistors 2 and 3 to terminals $T_2'$ and $T_2$ through aluminum wirings $Al_2$ and $Al_3$, respectively. Thus a semiconductor device having two

2

resistances with the theoretical ratio of 1 to 2 is obtained as illustrated in Fig. 1A. The equivalent circuit diagram of the device of Fig. 1A is illustrated in Fig. 1B. If all of the resistors 1, 2 and 3 have the same resistance R, the ratio between the resistance 1, which is the value of the resistor between the terminals $T_1$ and $T_1'$, and the resistance $(R_1 + R_2)$, which is the value of the resistor between the terminals $T_2$ and $T_2'$, is equal to the designed value which is 1 to 2.

A resistor having a resistance 2R can of course be made by forming a resistor having a length twice that of the basic resistor 1. However, in this case, the accuracy of the length is deteriorated, where the term "length" represents the length of the portion functioning as a resistor. That is, it is difficult to form a resistor to have a length exactly twice that of the basic resistor because displacement of positions often occur when windows are opened to make the terminals. In contrast to this, it is much easier to form a plurality of basic resistors having the exactly same length and to actualize the resistance 2R by connecting in series two of the basic resistors, as mentioned above with respect to the conventional device. This is an advantage in the above-mentioned conventional device.

However, there is still a problem in the conventional device. That is, as mentioned before, although each basic resistor has the same pattern, the resistances of the basic resistors are not always equal to each other. If the basic resistances $R_0$ to $R_2$ have some errors, and, for example, if these values are practically as follows:

$$R_0 = R$$

$$R_1 = R (1 + \Delta),$$

$$R_2 = (1 + 2\Delta),$$

respectively, then the practical ratio of the resistance between the terminals $T_1$ and $T_1'$ to the resistance between the terminals $T_2$ and $T_2'$ is:

$$\frac{R_1 + R_2}{R_0} = \frac{R (1 + \Delta) + R (1 + 2\Delta)}{R} = 2 + 3\Delta$$

Therefore, the practical ratio differs from the designed ratio by $3\Delta$.

As has been described above, it is assumed that each resistance differs from the neighboring resistors by the error $\Delta$. That is, the resistances increase or decrease along one direction under certain conditions. Such conditions are not special cases. For example, during a diffusion process for forming the resistors, semiconductor substrates, or, in other words, wafers are placed in a furnace so that they are subjected to heat treatment. In the furnace, heat is not always applied uniformly to each wafer becaue of various reasons. For example, supporting means for fixing the wafers in the furnace may act as a heat source to provide a linear temperature gradient on each wafer. In one chip of the semiconductor device, if there is a temperature difference during diffusion process for forming diffused type resistors, the error $\Delta$ of resistance value from the designed resistance will appear. Further, even when uniform resistances can be obtained in the fabricating process, such a linear temperature gradient may also be produced on each chip during operation of the semiconductor device, because semiconductor elements loaded on each chip generate heat to act as heat sources during the operation. For example, there may be a heat source such as an output transistor at the side of the resistor 3, and there may be no heat source at the side of the resistor 1. In such case, the temperature at the side of the resistor 3 is higher than the temperature at the side of the resistor 1. Accordingly, the resistance $R_2$ becomes higher than the resistance $R_0$, as will be understood when considering a temperature coefficient of a resistor in a semiconductor. The properties of IC resistors including the temperature coefficient are described in "Analysis and Design of Analog Integrated Circuits", Paul R. Gray & Robert G. Meyer, University of California, Berkeley, JOHN WILEY & SONS, copy right 1977, on page 105, Fig. 2.33.

The present invention provides a semiconductor device in which resistors are suitably connected to realize the desired ratios between resistances with a high accuracy. Fig. 2A is a plan view of a semiconductor device on which patterns of resistors are connected, according to an embodiment of the present invention. Referring to Fig. 2A, basic resistors 1, 2 and 3 in a diffused type resistor group RG are fabricated in the same way as in the conventional device. Let it be assumed that the resistances $R_0$, $R_1$ and $R_2$ of the resistors 1, 2 and 3 are R, $(R + \Delta)$ and $(R + 2\Delta)$, respectively, as in the conventional device of Fig. 1. According to the present invention, one end of the resistors 1 and 3 placed on opposite sides of resistor group RG are connected by an aluminum wiring $Al_{10}$. The other end of the resistor 1 is connected through an aluminum wiring $Al_{11}$ to a terminal $T_{20}$. Also, the other end of the resistor 3 is connected through an aluminum wiring $Al_{14}$ to a terminal $T_{20}'$. Thus, a series connected resistance $(R_0 + R_2)$ is formed between the terminals $T_{20}$ and $T_{20}'$. With respect to the resistor 2 placed in the middle portion of the resistor group RG, one end of the resistor $R_1$ is connected through an aluminum wiring $Al_{12}$ to a terminal $T_{10}$ and the other end is connected through an aluminum wiring $Al_{13}$ to a

terminal $T_{10}'$. Fig. 2B is an equivalent circuit diagram of Fig. 2A. The ratio of the resistance between the terminals $T_{10}$ and $T_{10}'$ to the resistance between terminals $T_{20}$ and $T_{20}'$ is:

$$\frac{R_0 + R_2}{R_1} = \frac{R + R(1 + 2\Delta)}{R(1 + \Delta)} = 2.$$

Therefore, in this embodiment, the error $\Delta$ is cancelled so that the desired ratio of resistances can be obtained accurately.

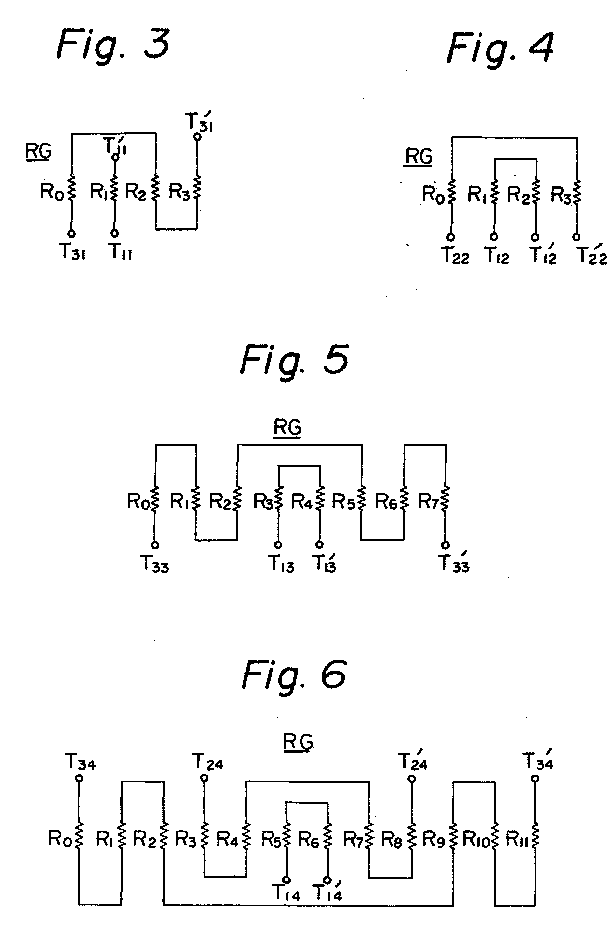

Figs. 3 to 6 are equivalent circuit diagrams of semiconductor devices, according to further embodiments of the present invention. In each of these devices, basic resistances $R_0$, $R_1$, ... $R_n$ are arranged on the semiconductor substrate in parallel fashion to form a diffused resistor group RG. The resistance values are assumed to be as follows:

$$R_0 = R$$

$$R_1 = R(1 + \Delta)$$

$$\cdot$$
$$\cdot$$
$$\cdot$$

$$R_n = R(1 + n\Delta)$$

In the second embodiment of the device of Fig. 3, the ratio of resistances 1:3 is nearly realized by connecting in series the resistances $R_0$, $R_2$ and $R_3$ which are placed on both sides of the resistance $R_1$. The accurate ratio of the first resistance $R_1$ between terminals $T_{11}$ and $T_{11}'$ to the second resistance $(R_0 + R_2 + R_3)$ between terminals $T_{31}$ and $T_{31}'$ can be calculated as follows.

$$\frac{R_0 + R_2 + R_3}{R_1} = \frac{R + R(1 + 2\Delta) + R(1 + 3\Delta)}{R(1 + \Delta)} = \frac{3 + 5\Delta}{1 + \Delta} \approx 3 + 2\Delta,$$

where, $\Delta$ is much smaller than 1. The error is nearly equal to $2\Delta$, which is very small in comparison with the error in the conventional device. In the conventional device, for example, the resistance $R_3$ is taken as the first resistance; and the resistance obtained by connecting the resistances $R_0$, $R_1$ and $R_2$ is taken as the second resistance. In this case, the error becomes about $-6\Delta$ which is much larger than the error in the second embodiment. It should be noted that, in place of taking the resistance $R_1$ as the first resistance, the resistance $R_2$ may be taken as the first resistance; and the resistance obtained by connecting the resistances $R_0$, $R_1$ and $R_3$ may be taken as the second resistance. In this case, the error is about $-2\Delta$, resulting in the same effect as in the above-mentioned second embodiment.

In general, it can not be determined at the designing stage whether the resistances increase from right to left or from left to right in the diffused resistor group RG. However, since the structure of the resistor group RG is symmetrical or almost symmetrical, as illustrated in Figs. 2A and 3, the same effect of small error is obtained regardless of the direction of the increase of the resistances.

Figs. 4 to 6 illustrate semiconductor devices of further embodiments of the present invention, in which completely symmetrical connections are presented to provide desired ratios of resistances completely, regardless of the increased number of resistors.

Referring to Fig. 4, the resistances $R_1$ and $R_2$ on the middle portion of the resistor group RG are connected in series to form the first resistance between terminals $T_{12}$ and $T_{12}'$, and the resistance $R_0$ and $R_3$ on both sides of the resistor group RG are connected in series to form the second resistance between terminals $T_{22}$ and $T_{22}'$, so that the ratio 1:1 is obtained between the first and second resistances. The ratio of the first resistance to the second resistance is calculated as:

$$\frac{R_0 + R_3}{R_1 + R_2} = \frac{R + R(1 + 3\Delta)}{R(1 + \Delta) + R(1 + 2\Delta)} = 1,$$

which is exactly the same as the designed value.

Referring to Fig. 5, the resistances $R_3$ and $R_4$ on the middle portion of the resistor group RG are connected in series to form the first resistance between terminals $T_{13}$ and $T_{13}'$; and the resistances $R_0$, $R_1$, $R_2$, $R_5$, $R_6$ and $R_7$ on both sides of the resistor group RG are connected in series to form the second resistance between terminals $T_{33}$ and $T_{33}'$, so that the exact ratio 1:3 without the error component $\Delta$ is obtained between the first resistance $(R_3 + R_4)$ and the second resistance

$$(R_0 + R_1 + R_2 + R_5 + R_6 + R_7).$$

4

In Fig. 6, three resistances are formed so that the exact ratios 1:2:3 without the error component $\Delta$ is obtained. That is, the resistances $R_5$ and $R_6$ on the middle portion of the resistor group RG are connected in series to form the first resistance $(R_5 + R_6)$ between terminals $T_{14}$ and $T_{14}'$; the resistances $R_3$, $R_4$, $R_7$ and $R_8$ on both sides of the first resistance are connected in series to form the second resistance $(R_3 + R_4 + R_7 + R_8)$ between terminals $T_{24}$ and $T_{24}'$; and, the resistances $R_0$, $R_1$, $R_2$, $R_9$, $R_{10}$ an $R_{11}$ on both sides of the resistor group RG are connected in series to form the third resistance

$$(R_0 + R_1 + R_2 + R_9 + R_{10} + R_{11})$$

between terminals $T_{34}$, $T_{34}'$. As will easily be calculated, the ratio

$$(R_5 + R_6) : (R_3 + R_4 + R_7 + R_8) : (R_0 + R_1 + R_2 + R_9 + R_{10} + R_{11})$$

is exactly equal to 1:2:3.

From the foregoing description, it is apparent that, according to the present invention, a high accuracy can be obtained with respect to the desired ratios between resistors which are formed with the same pattern on a semiconductor substrate, even when these resistances include errors. The present invention can be applied most effectively when these errors are due to a linear change in resistance values in one direction in the group of the resistors. When there is no error in each resistance, the present invention may of course be applied without any trouble.

Thus, an embodiment of this invention provides a semiconductor device of a monolithic type comprising a group of resistors having a plurality of basic resistors arranged in parallel fashion. Each basic resistance is formed by the same pattern so as to have a consistent resistance and an error resistance. The error resistance may be due to heat sources on the semiconductor substrate. In the ratio of a first resistor formed by connecting one or more of the basic resistors arranged on the middle portion of the group to a second resistor formed by connecting a plurality of basic resistors arranged on both sides of the first register, the component of the error resistance is substantially cancelled.

When a single basic resistor is to be employed a basic resistor substantially central of the group is used. When two or more basic resistors are to be employed connected together, basic resistors substantially symmetrically positioned in the group are connected together.

### Claims

1. A semiconductor device comprising: a semiconductor substrate; and, a group of resistors, including a plurality of basic resistors ($R_1$, $R_2$, ...) having the same pattern as one another, a predetermined number of the basic resistors being connected to form a resistor having a desired resistance value, characterised in that the group of resistors comprises: a first resistor constituted by one of the basic resistors, or formed by connecting together more than one of the basic resistors, the or each basic resistor of the first resistor being disposed in the middle portion of the group; and a second resistor formed by connecting together basic resistors disposed at opposite sides of the first resistor.

2. A semiconductor device as claimed in claim 1, wherein the basic resistors of the said plurality are arranged in parallel fashion on the semiconductor substrate.

3. A semiconductor device as claimed in claim 1 or 2, wherein the group of resistors further comprises a third resistor formed by connecting together basic resistors disposed outside the second resistor.

4. A semiconductor device as claimed in claim 1, 2 or 3, wherein the basic resistors are diffused type resistors formed in the semiconductor substrate.

5. A semiconductor device as claimed in claim 1, 2 or 3, wherein the basic resistors are thin film resistors formed on the semiconductor substrate.

### Revendications

1. Dispositif semi-conducteur, comprenant un substrat semi-conducteur, et, un groupe de résistances comprenant plusieurs résistances de base ($R_1$, $R_2$, ...) ayant la même configuration les une résistance ayant la valeur de résistance désirée, caractérisé en ce que le groupe des résistances une résistance ayant la valeur de résistance désirée, caractérisé en ce que le grope des résistances comporte une première résistance constituée par l'une des résistances de base ou formée en connectant ensemble plus d'une des résistances de base, la ou chaque résistance de base de la première résistance étant disposée dans la partie médiane du groupe, et une seconde résistance formée en connectant ensemble des résistances de base disposées sur les côtés opposés de la première résistance.

2. Dispositif semi-conducteur selon la revendication 1, dans lequel les résistances de base desdites plusieurs résistances sont disposées parallèlement sur le substrat semi-conducteur.

3. Dispositif semi-conducteur selon la revendication 1 ou 2, dans lequel le groupe des résistances comporte en outre une troisième résistance formée en connectant ensemble des résistances de base disposées de l'extérieur de la seconde résistance.

4. Dispositif semi-conducteur selon la revendication 1, 2 ou 3, dans lequel les résistances de base sont des résistances du type diffusé formées dans le substrat semi-conducteur.

5. Dispositif semi-conducteur selon la revendication 1, 2 ou 3, dans lequel les résistances de base sont des résistances en pellicule mince formées sur le substrat semi-conducteur.

**Patentansprüche**

1. Halbleitervorrichtung mit einem Halbleitersubstrat und einer Gruppe von Widerständen, welche eine Mehrzahl von Basiswiderständen ($R_1$, $R_2$, ...) aufweisen, die alle dasselbe Muster haben, und von denen eine vorbestimmte Anzahl verbunden ist, um einen Widerstand mit einem gewünschten Widerstandswert zu bilden, dadurch gekennzeichnet, daß die Gruppe von Widerständen einen ersten Widerstand umfaßt, welcher aus einem der Basiswiderstände oder durch Verbinden mehrerer der Basiswiderstände gebildet ist, wobei der oder jeder Basiswiderstand des ersten Widerstandes im mittleren Abschnitt der Gruppe angeordnet ist, und einen zweiten Widerstand, welcher durch Verbinden mehrerer Basiswiderstände miteinander gebildet ist, die an entgegengesetzten Seiten des ersten Widerstands angeordnet sind.

2. Halbleitervorrichtung nach Anspruch 1, bei welcher die Basiswiderstände der genannten Mehrzahl auf dem Halbleitersubstrat in paralleler Art angeordnet sind.

3. Halbleitervorrichtung nach Anspruch 1 oder 2, dadurch gekennzeichnet, daß die Gruppe der Widerstände ferner einer dritten Widerstand umfaßt, welcher durch Zusammenschließen von Basiswiderständen gebildet ist, die außerhalb des zweiten Widerstandes liegen.

4. Halbleitervorrichtung nach Anspruch 1, 2 oder 3, dadurch gekennzeichnet, daß die Basiswiderstände diffundierte Widerstände sind, welche in dem Halbleitersubstrat ausgebildet sind.

5. Halbleitervorrichtung nach einem der Ansprüche 1, 2 oder 3, dadurch gekennzeichnet, daß die Basiswiderstände auf dem Halbleitersubstrat ausgebildete Dünnschichtwiderstände sind.

# Fig. IA

# Fig. IB

# Fig. 2A

# Fig. 2B

1

# *Fig. 3*

# *Fig. 4*

# *Fig. 5*

# *Fig. 6*